Europäisches Patentamt

European Patent Office

Office européen des brevets

(19)

(11) Numéro de publication: **0 099 778**

**A1**

(12) **DEMANDE DE BREVET EUROPEEN**

(21) Numéro de dépôt: 83401282.5

(22) Date de dépôt: 21.06.83

(51) Int. Cl.³: **H 01 J 37/20**
**H 01 J 37/317, C 23 C 15/00**
**C 23 C 13/00**

---

(30) Priorité: 24.06.82 FR 8211077

(43) Date de publication de la demande:
01.02.84 Bulletin 84/5

(84) Etats contractants désignés:
DE FR GB NL

(71) Demandeur: COMMISSARIAT A L'ENERGIE ATOMIQUE
Etablissement de Caractère Scientifique Technique et
Industriel
31/33, rue de la Fédération
F-75015 Paris(FR)

(72) Inventeur: Bruel, Michel
Presvert No. 9
F-38113 Veurey(FR)

(72) Inventeur: Escaron, Jean
Le Plaçage No. 3
F-38360 Sassenage(FR)

(72) Inventeur: Labartino, Joseph
Lotissement Les Cerisiers
F-38340 Voreppe(FR)

(74) Mandataire: Mongrédien, André et al,
c/o BREVATOME 25, rue de Ponthieu
F-75008 Paris(FR)

---

(54) **Porte-cibles à balayage mécanique.**

(57) Porte-cibles à balayage mécanique.
Le dispositif comprend plusieurs supports de cibles (6, 8) montés sur un plateau (2) mobile en rotation autour d'un axe (XX') et des moyens de déplacement des supports par rapport au plateau (2) agencés de telle sorte que l'incrément de déplacement radial d'un support (6) entre deux passages consécutifs devant le faisceau (F) soit constant pendant la durée d'une excursion entre les deux positions extrêmes du support (6).
Application à l'implantation d'ions sur une plaquette de silicium.

FIG. 1

EP 0 099 778 A1

La présente invention a pour objet un porte-cibles à balayage mécanique permettant un dépôt ou une implantation homogène sur une ou plusieurs cibles montées sur le dispositif, ce dépôt ou cette implantation étant obtenu à l'aide d'une source d'énergie.

De nombreuses applications nécessitent que des cibles soient frappées par un faisceau énergétique ou un flux de particules, par exemple l'implantation d'ions sur une plaquette de silicium destinée à la réalisation de circuits intégrés. Etant donné que le diamètre du faisceau est généralement très inférieur aux dimensions de la cible, le principal problème qui se pose dans ce genre d'application est celui de l'homogénéité de l'implantation.

Les différents systèmes utilisés à ce jour peuvent se classer en deux grandes catégories : les systèmes mécaniques et les systèmes électriques. Dans le cas des systèmes mécaniques, les cibles sont montées sur un support qui se déplace devant le faisceau qui, lui, est fixe. Le déplacement du support s'effectue selon deux mouvements croisés : un mouvement dit lent et un mouvement dit rapide, perpendiculaire au mouvement dit lent. Dans l'art antérieur, pour la réalisation du mouvement rapide, les cibles peuvent par exemple être placées sur un tambour tournant autour d'un axe perpendiculaire au faisceau ou montées sur un support déformable entraîné par deux roues motrices. Il existe encore un système dans lequel les cibles placées sur un tambour gardent constamment la même orientation, c'est-à-dire restent parallèles à elles-mêmes et donc perpendiculaires au faisceau. Le mouvement lent dans les cas précédents est un mouvement de translation alterné dans une direction parallèle aux axes de rotation.

B 7521.3 JR

Le principal inconvénient de ces dispositifs est que les mouvements sont lents et que le
risque d'inhomogénéité d'implantation est grand à
cause des variations d'intensité du faisceau malgré le
mouvement de va-et-vient qui se superpose au mouvement
de rotation. D'autre part, les mouvements des cibles
peuvent être tels que l'orientation de ces dernières
par rapport au faisceau est variable et l'angle d'incidence n'est pas le même en tous les points de la
cible. Si ces défauts n'ont guère d'importance lorsque
les plaques sont de petites dimensions, ils deviennent
prohibitifs lorsque la taille de celles-ci augmente,
car les conditions d'impact peuvent varier de manière
importante d'un point à un autre.

Une autre catégorie de dispositifs utilise
des plateaux sur lesquels sont montées les cibles,
l'axe de rotation du plateau étant parallèle au
faisceau. Le mouvement rapide est dans ce cas la rotation, le mouvement lent étant réalisé par un déplacement, parallèlement à lui-même, de l'axe de rotation
du plateau, dans un plan passant par l'axe du
faisceau. Ce dispositif présente l'avantage que l'angle d'incidence du faisceau sur la cible est constant.
Mais il présente l'inconvénient que le rayon de la
trajectoire du faisceau sur la cible est variable. Les
traces ne sont pas parallèles et si la vitesse de rotation est constante, la vitesse linéaire relative du
faisceau et de la cible est variable et dépend de la
distance faisceau-axe de rotation. Ceci implique la
nécessité de systèmes de contre-réaction sur la vitesse lente de façon à obtenir une bonne homogénéité sur
la cible.

Dans les systèmes électriques, les cibles
sont fixes, mais on réalise un balayage en faisant
varier la direction du faisceau d'ions. Etant donné

B 7521.3 JR

que les angles de déflexion augmentent avec la dimension des plaques, ceci entraîne des inhomogénéités d'implantation malgré les corrections électroniques apportées sur le temps de balayage.

La présente invention a justement pour objet de remédier à ces inconvénients en proposant un porte-cibles à balayage mécanique qui permette d'obtenir une excellente homogénéité d'implantation sur les cibles.

Selon la principale caractéristique du porte-cibles objet de l'invention, celui-ci, du type comportant plusieurs supports de cibles montés sur un plateau mobile en rotation par rapport à un axe afin que lesdits supports passent à tour de rôle devant un faisceau énergétique fixe par rapport à l'axe de rotation du plateau, se caractérise en ce qu'il comporte des moyens permettant de déplacer chaque support par rapport au plateau, l'agencement desdits moyens de déplacement étant tel que l'incrément de déplacement radial d'un support entre deux instants correspondant à deux passages consécutifs du support devant le faisceau soit constant pendant la durée d'une excursion entre les positions extrêmes et tel que le support aie toujours la même orientation par rapport au plateau à chaque passage devant le faisceau.

Le mouvement des supports est un mouvement de va-et-vient, de préférence suivant une direction radiale : dans ce cas, deux supports différents se déplacent suivant deux rayons différents du plateau et deux supports adjacents se déplacent en sens opposé. Dans la présente invention, le plateau mobile en rotation peut être remplacé par toute autre pièce mécanique de forme différente, pourvu que l'agencement des moyens de déplacement permette d'obtenir le même résultat. La présente invention est caractérisée par des conditions à respecter sur l'incrément de déplacement radial des supports par rapport au plateau. Il est à

B 7521.3 JR

remarquer que ceci n'implique en rien que le déplacement soit uniquement radial et en outre n'implique pas de conditions sur la cinématique des supports entre deux passages consécutifs devant le faisceau. La position et l'orientation des supports doivent respecter des règles bien précises uniquement aux instants correspondant au passage devant le faisceau. La seule condition à respecter est que l'incrément de déplacement radial soit constant entre deux passages consécutifs devant le faisceau et il n'y a aucune condition particulière sur les autres composantes du déplacement.

Suivant un premier mode de réalisation de l'invention, les moyens permettant de déplacer chaque support par rapport au plateau comprennent :
- une rainure radiale le long de laquelle le support peut coulisser,
- un premier arbre moteur servant à entraîner le plateau en rotation, et
- un câble reliant deux supports adjacents et passant sur au moins une poulie solidaire de l'arbre.

Selon une autre caractéristique de ce premier mode de réalisation, les moyens permettant de déplacer chaque support par rapport au plateau comprennent un barillet monté sur l'arbre, immobilisé en rotation mais libre en translation par rapport à ce dernier, le barillet étant équipé d'un doigt apte à coopérer avec une rainure ménagée dans une pièce intermédiaire pouvant tourner autour du même axe que l'arbre, les vitesses de rotation de l'arbre et de la pièce étant généralement différentes.

Dans ce cas, le barillet comporte avantageusement au moins deux passages pour un câble reliant deux supports adjacents, l'un des deux passages étant équipé de moyens permettant de fixer par rapport au barillet l'un des brins du câble.

Dans un deuxième mode de réalisation, les moyens permettant de déplacer chaque support par rapport au plateau comprennent :

- une rainure radiale le long de laquelle le support peut coulisser,

- une tige cylindrique munie d'une rainure de guidage hélicoïdale, disposée parallèlement à la rainure précitée et ayant ses extrémités fixées par rapport au plateau, la tige étant libre en rotation, et

- une pièce de liaison solidaire du support et de la tige, ladite pièce de liaison étant immobilisée en rotation mais libre en translation par rapport à la tige.

Enfin, selon une autre caractéristique de ce deuxième mode de réalisation, les moyens permettant de déplacer chaque support par rapport au plateau comprennent en outre une pièce intermédiaire équipée d'un pignon apte à coopérer avec un autre pignon disposé à une extrémité de la tige.

L'invention apparaîtra mieux à la lecture de la description qui va suivre, donnée à titre purement illustratif et nullement limitatif, en référence aux dessins annexés, dans lesquels :

- la figure 1 est une vue schématique en perspective et partiellement en coupe d'un premier mode de réalisation du porte-cibles selon l'invention ;

- la figure 2 est une vue schématique en coupe représentant les moyens de déplacement de deux supports de cibles adjacents, rabattus sur un même plan ; et

- la figure 3 est une vue schématique en coupe illustrant un deuxième mode de réalisation du porte-cibles selon l'invention.

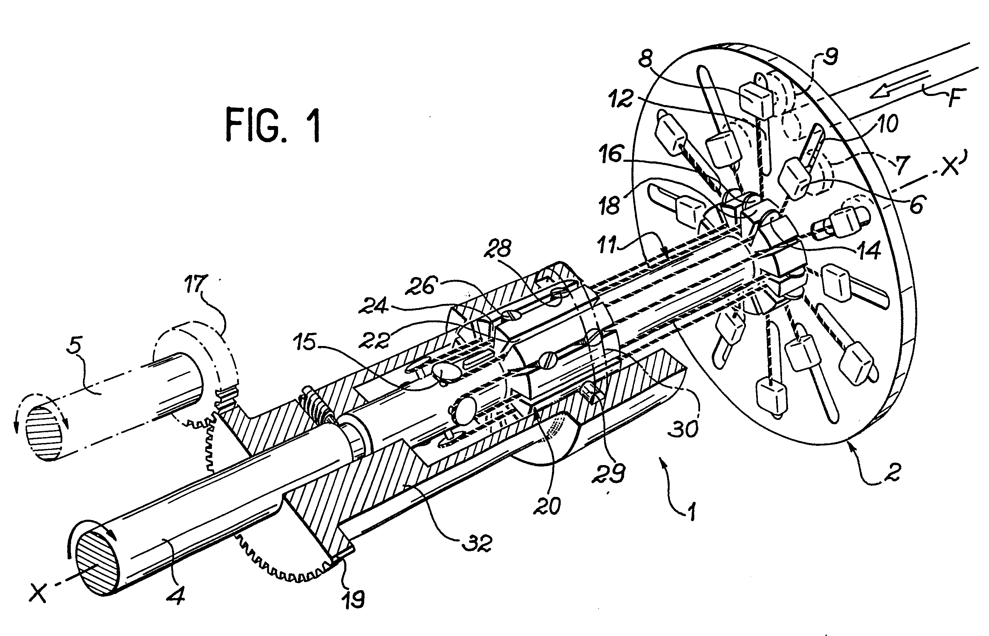

Si l'on se reporte à la figure 1, on voit que le dispositif objet de l'invention, portant la référence générale 1, se compose essentiellement d'un plateau circulaire 2 mobile en rotation autour d'un axe XX' perpendiculaire à son plan grâce à un arbre moteur 4. Un faisceau énergétique F, par exemple un faisceau d'ions, parallèle à l'axe XX', peut frapper les cibles telles que 7 et 9 montées sur les supports 6 et 8 respectivement. Afin que ceux-ci puissent se déplacer par rapport au plateau, on a prévu des rainures telles que 10 et 12 le long desquelles les supports 6 et 8 peuvent coulisser. Dans l'exemple représenté ici, il y a douze rainures disposées suivant des rayons du plateau mais ce nombre n'est pas impératif et l'on peut prévoir un nombre quelconque de supports, mais de préférence un nombre pair. On voit encore sur la figure que les supports 6 et 8 sont reliés par un câble 11 dont une première extrémité est fixée au support 6 et l'autre extrémité au support 8. Partant du support 6, le câble passe tout d'abord dans une poulie 14 montée sur un tambour 18 solidaire du plateau 2, le plan de la poulie 14 étant confondu avec celui défini par l'axe XX' et la rainure 10. Le câble chemine ensuite parallèlement à l'arbre 4 avant de passer sur une poulie 15 solidaire de cet arbre et de revenir, toujours parallèlement à ce dernier, jusqu'à une autre poulie 16 montée sur le tambour 18 de la même façon que la poulie 14, tandis que son autre extrémité est fixée au support 8. On voit encore sur la figure 1 un barillet 20 monté sur l'arbre 4 : le barillet 20 est solidaire en rotation de l'arbre 4, mais peut se déplacer en translation le long de celui-ci. Le barillet 20 porte des passages parallèles associés deux par deux, tels que les passages longitudinaux 22 et 24 pour le câble 11 qui relie les supports 6 et 8. Le passage 24 est équipé de deux vis 26 et 28 dont le rôle est de fixer au barillet 20 le brin du câble correspondant au support 8. D'autre part, le barillet est équipé d'un doigt 29 apte à coopérer avec une rainure 30, représentée schématiquement en traits mixtes, ménagée à l'intérieur d'une pièce intermédiaire 32 représentée en coupe sur la figure. La pièce 32, qui est
concentrique à l'arbre 4, est entraînée en rotation
par un deuxième arbre moteur 5 se terminant par un
pignon 17 apte à engrener sur un autre pignon 19 solidaire de ladite pièce 32.

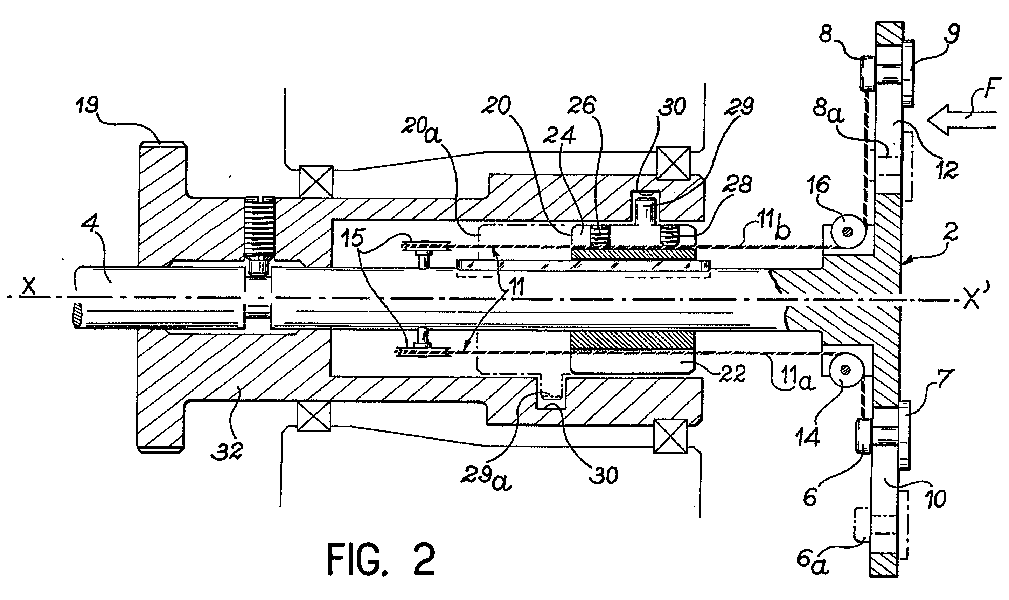

On va maintenant décrire le fonctionnement
de l'appareil à l'aide de la figure 2 sur laquelle on
a représenté une vue en coupe du dispositif, celui-ci
étant coupé par deux plans contenant chacun l'axe XX',
mais passant l'un par la rainure 12 du support 8 et
l'autre par la rainure 10 du support 6, les deux vues
étant rabattues sur un même plan pour plus de clarté.
On retrouve donc sur la figure 2 le plateau 2 avec les
rainures 10 et 12 le long desquelles se déplacent les
supports 6 et 8 respectivement. On voit aussi que le
câble 11 comporte deux brins dont le premier 11a passe
librement dans le passage 22 du barillet 20 tandis que
l'autre brin 11b est fixé dans le passage 24 à l'aide
des vis 26 et 28.

Etant donné que l'arbre 4 et la pièce intermédiaire 32 tournent autour de l'axe XX' avec des vitesses différentes, le mouvement de la pièce 32 a pour
effet d'entraîner le barillet 20 longitudinalement le
long de l'arbre 4 par l'intermédiaire du doigt 29 qui
coopère avec la rainure 30. C'est ainsi que le barillet peut venir en une position 20a représentée schématiquement en traits mixtes sur la figure tandis que le
doigt 29 vient en une position 29a. Puisque le brin
11b du câble est fixe par rapport au barillet, ce mouvement a pour effet d'entraîner le support 8 jusqu'à
la position 8a représentée également en traits mixtes,
tandis que le brin 11a se déplace en sens inverse du
brin 11b, laissant le support 6 aller jusqu'à une position 6a située à la périphérie du plateau. Dans

B 7521.3 JR

l'exemple décrit ici, les supports tels que 6 et 8 sont constamment sollicités vers l'extérieur du plateau, par la force centrifuge lorsque ce dernier tourne, mais on peut utiliser d'autres moyens, par exemple des ressorts ou n'importe quel système équivalent.

On voit donc qu'en agissant sur les vitesses de rotation de l'arbre 4 et de la pièce 32, ainsi que sur la forme de la rainure 30, on peut obtenir toutes les combinaisons possibles entre le mouvement de rotation du plateau et les mouvements de translation des supports le long des rainures correspondantes. A titre d'exemple, on a réalisé un tel dispositif dans lequel il faut cinq tours du plateau pour qu'un support fasse un trajet simple entre les points extrêmes de la rainure correspondante. On voit encore sur la figure 2 que le faisceau F frappe le plateau en un point situé sensiblement au milieu de la rainure 12. Ainsi, à chaque passage de la rainure 12 devant le faisceau F, c'est une partie différente de la cible 9 placée sur le support 8 qui est frappée par le faisceau puisque le porte-cible ne se déplace, entre deux passages consécutifs, que d'une fraction relativement faible de la longueur de la rainure, par exemple $1/5^e$ ou moins. On peut encore introduire un léger glissement à chaque point de rebroussement du mouvement des supports (soit vers le centre du plateau, soit vers la périphérie de celui-ci) afin d'introduire un autre décalage lors de chaque passage de la cible devant le faisceau F, ce qui réduit considérablement la probabilité de voir la même portion de la cible frappée deux fois par le faisceau F. Le fait que deux supports voisins tels que 6 et 8 aient des mouvements en sens inverse permet de réduire l'encombrement du dispositif et de placer un nombre maximal de supports sur un plateau de dimensions données, mais ceci n'est pas obligatoire.

7521.3 JR

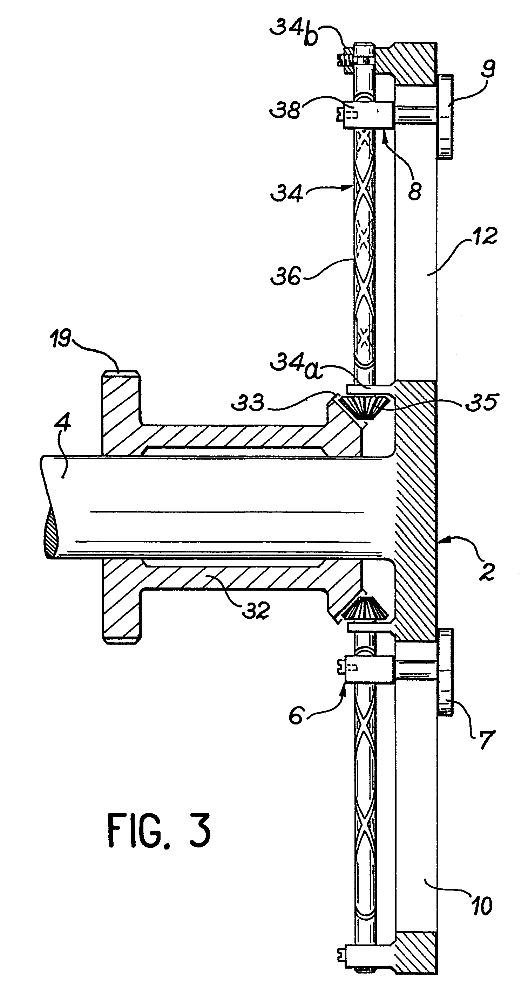

La figure 3 illustre un autre mode de réalisation dans lequel le système de câbles est remplacé par un système du genre vis-écrou. On voit qu'à chaque support 8 est associée une tige 34 disposée parallèlement à la rainure 12 et dont les extrémités 34a et 34b sont fixées au plateau 2 respectivement vers le centre et la périphérie de ce dernier. La tige 34 est ainsi immobilisée en translation mais libre en rotation autour de son axe. Elle comporte un guidage hélicoïdal double à pas inversé 36 qui coopère avec une pièce de liaison 38 rendue solidaire du support 8. La pièce 38 ne pouvant se déplacer qu'en translation parallèlement à la rainure 12 et gardant toujours la même orientation par rapport à celle-ci, il est clair que les mouvements de rotation de la tige 34 entraînent un déplacement longitudinal de la pièce de liaison 38 le long de ladite tige 34. Dans l'exemple particulier illustré à la figure 3, on voit que la pièce intermédiaire 32 se termine par un pignon 33 qui engrène sur un autre pignon 35 situé à l'extrémité 34a de la tige 34. Là encore, en agissant sur les vitesses de rotation de l'arbre 4 et de la pièce 32, et en choisissant convenablement le dessin des rainures de guidage 36 qui équipent la tige 34, on peut combiner les mouvements de rotation du plateau 2 avec les mouvements de translation des supports 6 et 8 le long des rainures 10 et 12. De plus, on peut choisir la configuration de la rainure 36 aux extrémités de la tige de manière à introduire un décalage à chaque point de rebroussement des porte-cibles.

Le dispositif selon l'invention présente des avantages particulièrement intéressants, dont le principal est qu'il permet d'obtenir une bonne homogénéité puisque les caractéristiques suivantes sont respectées :

B 7521.3 JR

- les trajectoires relatives du faisceau et de chaque cible sont à rayon constant puisque la distance entre le faisceau F et l'axe de rotation du plateau est constante, donc le balayage se fait à vitesse linéaire constante si la vitesse de rotation du plateau est constante ;
- l'écart entre 2 trajectoires consécutives est constant ;
- en outre il suffit que la vitesse de rotation soit constante, ou peu variable, pendant la durée d'une excursion radiale pour que la condition d'homogénéité soit respectée. De plus, grâce au décalage que l'on introduit à chaque rebroussement, aucune des trajectoires du faisceau sur les cibles n'en recouvre exactement une autre.

Il est bien entendu que l'invention ne se limite pas aux deux modes de réalisation qui viennent d'être décrits, mais qu'on peut en envisager d'autres sans sortir pour autant du cadre de l'invention, le but étant de combiner les mouvements de rotation du plateau avec les mouvements de translation des supports de cible le long des rainures. En particulier il est possible de choisir une vitesse radiale des supports de cibles différente pour chacun des 2 sens de déplacement radial des supports. Ainsi par exemple, on peut réaliser un mouvement radial lent du centre vers la périphérie, suivi d'un retour rapide. Pour cela, il suffit, dans le premier mode de réalisation, de donner à la rainure 30 la forme d'une double hélice à pas opposés et de valeurs différentes.

Une simplification du système peut être apportée si le nombre des supports est choisi égal à 6 + 4n, où n est un nombre entier : en effet, le respect de cette condition permet d'associer solidairement deux supports diamétralement opposés, tout en conservant le fait que deux supports adjacents ont des mouvements radiaux opposés. On gagne ainsi au point de vue du dimensionnement et on divise par deux le nombre de systèmes à déplacer par rapport au plateau.

B 7521.3 JR

REVENDICATIONS

1. Porte-cibles à balayage mécanique, du type comportant plusieurs supports de cibles (6, 8) montés sur un plateau (2) mobile en rotation autour d'un axe (XX') afin que lesdits supports passent à tour de rôle devant un faisceau énergétique (F) fixe par rapport à l'axe (XX'), caractérisé en ce qu'il comporte des moyens permettant de déplacer chaque support (6) par rapport au plateau (2) entre deux positions extrêmes, l'agencement desdits moyens de déplacement étant tel que l'incrément de déplacement radial d'un support (6) entre deux instants correspondant à deux passages consécutifs du support (6) devant le faisceau F soit constant pendant la durée d'une excursion entre les positions extrêmes et tel que le support (6) aie toujours la même orientation par rapport au plateau (2) à chaque passage devant le faisceau (F).

2. Porte-cibles selon la revendication 1, caractérisé en ce que l'agencement desdits moyens de déplacement est tel que le déplacement des supports (6,8) par rapport au plateau (2) est purement radial.

3. Porte-cibles selon la revendication 2, caractérisé en ce que l'agencement desdits moyens de déplacement est tel que le mouvement radial est un mouvement de va-et-vient.

4. Porte-cibles selon la revendication 2, caractérisé en ce que l'agencement desdits moyens de déplacement est tel que, à chaque support correspond une direction distincte de déplacement radial.

5. Porte-cibles selon la revendication 3, caractérisé en ce que l'agencement desdits moyens de déplacement est tel que deux supports adjacents quelconques (6, 8), ont des mouvements radiaux opposés.

6. Porte-cibles selon la revendication 5,

B 7521.3 JR

caractérisé en ce que le nombre des supports est égal à 6 + 4n, n étant un nombre entier.

7. Porte-cibles selon la revendication 6, caractérisé en ce qu'il comporte des moyens permettant d'associer deux supports diamétralement opposés.

8. Porte-cibles selon l'une quelconque des revendications 1 à 7, caractérisé en ce que les moyens permettant de déplacer chaque support (6) par rapport au plateau (2) comprennent :

- une rainure (10) le long de laquelle le support (6) peut coulisser,

- un premier arbre moteur (4) servant à entraîner le plateau (2) en rotation, et

- un câble (11) reliant deux supports adjacents (6, 8) et passant sur au moins une poulie (15) solidaire de l'arbre (4).

9. Porte-cibles selon la revendication 8, caractérisé en ce que les moyens permettant de déplacer chaque support (6) par rapport au plateau (2) comprennent en outre un barillet (20) monté sur l'arbre (4), immobilisé en rotation mais libre en translation par rapport à ce dernier, le barillet (20) étant équipé d'un doigt (29) apte à coopérer avec une rainure (30) ménagée dans une pièce intermédiaire (32) pouvant tourner autour du même axe (XX') que l'arbre (4), les vitesses de rotation de l'arbre (4) et de la pièce (32) étant généralement différentes.

10. Porte-cibles selon la revendication 9, caractérisé en ce que le barillet (20) comprend au moins deux passages (22, 24) pour un câble (11) reliant deux supports adjacents (6, 8), l'un (24) des deux passages étant équipé de moyens permettant de fixer par rapport au barillet (20) l'un des brins (11b) du câble (11).

11. Porte-cibles selon l'une quelconque des revendications 1 à 5, caractérisé en ce que les moyens permettant de déplacer chaque support (8) par rapport au plateau (2) comprennent :

- une rainure (12) le long de laquelle le support (8) peut coulisser,
- une tige cylindrique (34) munie de rainures de guidage (36), disposée parallèlement à la rainure (12) et ayant ses extrémités fixées par rapport au plateau (2), la tige (34) étant libre en rotation, et
- une pièce de liaison (38) solidaire du support (8) et de la tige (34), ladite pièce de liaison (38) étant immobilisée en rotation mais libre en translation par rapport à la tige (34).

12. Porte-cibles selon la revendication 11, caractérisé en ce que les moyens permettant de déplacer chaque support(8) par rapport au plateau (2) comprennent en outre une pièce intermédiaire (32) équipée d'une couronne dentée (33) apte à coopérer avec un pignon (35) disposé à une extrémité de la tige (34).

B 7521.3 JR

FIG. 1

FIG. 2

FIG. 3

Office européen
des brevets

**RAPPORT DE RECHERCHE EUROPEENNE**

Numéro de la demande

EP 83 40 1282

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | US-A-3 993 909 (DREWS et al.) <br> * Figure; colonne 1, ligne 57 - colonne 2, ligne 11; colonne 2, lignes 61-68 * | 1 | H 01 J 37/20 <br> H 01 J 37/317 <br> C 23 C 15/00 <br> C 23 C 13/00 |
| A | US-A-4 274 004 (KANAI) <br> * Figures 1-3; colonne 1, lignes 1-32 * | 1 | |
| A | DE-A-3 114 466 (HITACHI) | | |
| A | FR-A-2 298 880 (C.E.A.) | | |

---

**DOMAINES TECHNIQUES RECHERCHES (Int. Cl. ³)**

H 01 J 37
C 23 C 13
C 23 C 14
C 23 C 15

Le présent rapport de recherche a été établi pour toutes les revendications

| Lieu de la recherche <br> LA HAYE | Date d'achèvement de la recherche <br> 30-09-1983 | Examinateur <br> SCHAUB G.G. |
|---|---|---|